# EUROPEAN PATENT APPLICATION

(11) **EP 4 521 892 A1**
(43) Date of publication of application: **12.03.2025**
(21) Application number: 23196457.8
(22) Date of filing: 11.09.2023
(51) Int. Cl.: H10K 30/40, H10K 85/50, H10K 30/57, H10K 71/16

(54) **OPTOELECTRONIC COMPONENT COMPRISING AN INORGANIC PEROVSKITE SUBCELL AND A PROCESS FOR MANUFACTURING SUCH INORGANIC PEROVSKITE SUBCELL OF AN OPTOELECTRONIC COMPONENT**

(71) Applicant: Heliatek GmbH, 01139 Dresden (DE)
(72) Inventor: WEISS, Andre, 01139 Dresden (DE); UHRICH, Christian, 01139 Dresden (DE); LE, Phuong, 01139 Dresden (DE)

(57) **Abstract**

The present invention relates to an optoelectronic component (100) comprising a transparent front electrode (2), a back electrode (8), and a stack (20) arranged between the front electrode (2) and the back electrode (8), the stack (20) comprising an inorganic perovskite subcell (12), wherein the inorganic perovskite subcell (12) having a n-i-p cell architecture, and a process for manufacturing such an inorganic perovskite subcell (12) of an optoelectronic component (100) by vacuum deposition on a substrate (1), wherein the inorganic perovskite subcell (12) having a n-i-p cell architecture.

## Description

The present invention relates to an optoelectronic component comprising a transparent front electrode, a back electrode, and a stack arranged between the front electrode and the back electrode, the stack comprising an inorganic perovskite subcell, wherein the inorganic perovskite subcell having a n-i-p cell architecture, and a process for manufacturing an inorganic perovskite subcell of an optoelectronic component by vacuum deposition on a substrate, wherein the inorganic perovskite subcell having a n-i-p cell architecture.

The power conversion efficiency (PCE) of perovskite solar cells (PSC) increased significantly during the last years. Perovskite solar cells have attracted increasing interest due to their photophysical properties as well as commercial applications.

Perovskite solar cells can be manufactured by solution-processing techniques or by vacuum deposition. The manufacturing of perovskite solar cells by vacuum deposition, which is a widely adopted technology in the coating and semiconductor industry, is of advantage for large scale production. Vacuum deposition allows strict control over composition and thickness of layers of the perovskite solar cell. Vacuum deposition of perovskite solar cells usually involves the co-sublimation of at least two kinds of precursors in a vacuum chamber which together from the perovskite structure.

Avila et al. (`Vapor-Deposited Perovskites: The Route to High-Performance Solar Cell Production?', Joule 1, 2017, November 15, 431-442) discloses fundamentals of perovskite vapor-related techniques. The most employed vacuum-based technique is the dual-source co-deposition of perovskite precursors which allows tuning the composition of the final film. Fully inorganic perovskites need a high-temperature treatment or post-annealing to modify the morphology of the deposited perovskite structure.

Organic-inorganic ("hybrid") perovskites have a low thermal stability due to the volatile organic cations typically used. Furthermore, due to the different vapour pressures of the respective precursors, vacuum deposition of hybrid perovskites is very challenging. All-inorganic perovskites have a higher intrinsic thermal stability compared to their hybrid counterparts, due to the absence of volatile cations. The higher robustness makes them more suitable for industrialization, in particular all-inorganic perovskites are known to be processable by vapor deposition.

Chiang et al. (ACS, Energy Lett., 2020, 5, 2498-2504) discloses multisource vacuum deposition of Methylammonium-free perovskite solar cells with high quality morphological, structural, and optoelectronic properties. The production of pin solar cells by vacuum deposition is sensitive to a range of parameters, including substrate, annealing temperature, and evaporation rates.

Qiu et al. (Aggregate., 2021, 2, 66-83) discloses engineering of inorganic lead halide perovskite deposition of solar cells by tuning the precursor crystallization kinetics performing post-deposition treatments.

However, for vacuum deposited inorganic perovskites during processing high substrate temperature is required or after deposition of the layers a post annealing step, in particular a thermal annealing step, is required, which is typically at high temperature above 150°C, in most cases even above 250°C, in order to form a stable perovskite structure which has a high power conversion efficiency (PCE). This annealing step represents an additional processing step that requires time and energy. This annealing step further requires that all components of the stack and the substrate underneath the all-inorganic perovskite layer can withstand the conditions of the annealing step, which clearly limits the choice of respective materials. In particular, on temperature sensitive substrates, e.g. polymer films of PET, which allow the production of flexible solar cells, such an annealing at high temperature is not applicable.

In particular it requires that the substrate used for deposition of the stack can withstand the conditions of increased substrate temperature during deposition and/or the temperature of the annealing step. However, many different kinds of substrates, in particular films, e.g. many PET films, change their mechanical properties starting around 100°C to 120°C. Belt tensions that apply typically in roll-to-roll processes can cause severe problems with PET based films if processing temperatures exceed 100°C or even more. vacuum under conditions acceptable for the substrate. Even the best thermally stabilized PET films, such as the biaxially oriented PET product ST504 from DuPont, still shows shrinkage of 0.05% to 0.1% at temperatures from 150°C. Shrinkage greater than 0.1% leads to considerable manufacturing problems, since structures that have already been applied (e.g. laser structuring) shift in position; identification marks become illegible. Inhomogeneous heating of the substrate leads to additional challenges. Any resulting waviness or inhomogeneities in optical properties can significantly affect further processing, aesthetic appearance, and functionality of the product. Shrinkage at elevated temperatures is additionally intensified by the tape tension required in the roll-to-roll process, which allows a substrate temperature of maximum 120°C in the production process. Less thermally stabilized PET films increase the problem and require a further lowering of the maximum allowable substrate temperature in the manufacturing process.

Hence, to date it is not possible to process inorganic perovskites on a PET based substrate, which is the most frequently used substrate material for flexible photovoltaic devices. Furthermore, it is not possible to produce inorganic perovskites by roll-to-roll processing using a PET substrate. Therefore, it is desirable to manufacture the perovskite subcell by means of processing in vacuum under conditions acceptable for the substrate. Furthermore, combining wide band-gap inorganic perovskite subcells providing high efficiency in the blue-green spectral range and narrow band-gap organic subcells providing high efficiency in the red-near-infrared spectral range in a tandem device is expected to be an effective approach to absorb radiation in a broad range of wavelengths for increasing the performance of solar cells. For inorganic perovskite subcells as well as organic subcells all-vacuum deposition is a widely used technology which allows manufacturing in the same equipment.

Wang et al. (Recent progress and prospects of integrated perovskite/organic solar cells, Applied Physics Reviews, 7, 2020, 031303) discloses tandem solar cells which combine perovskite, silicon, copper indium gallium diselenide, quantum dots and organic solar cells in a multi-junction approach.

The underlying technical problem of the present invention is to overcome the before mentioned problems, in particular to provide a structure of an inorganic perovskite subcell for a solar cell and a method for manufacturing such an inorganic perovskite subcell by vacuum deposition, wherein in particular processing at low substrate temperature is possible, and annealing at low temperature is sufficient or even no annealing is required. Furthermore, the optoelectronic component comprising the inorganic perovskite subcell should be suitable to be manufactured in a roll-to-roll process by vacuum deposition on a substrate, in particular a flexible substrate.

The object is achieved by means of the subject-matter of the independent claims. Advantageous embodiments are evident from the dependent claims.

The object of the present invention is in particular solved by an optoelectronic component, preferably a photovoltaic element, comprising a transparent front electrode, a back electrode, and a stack arranged between the front electrode and the back electrode, the stack comprising an inorganic perovskite subcell. The inorganic perovskite subcell having a n-i-p cell architecture comprising in sequence the following layers:
b) an n-type layer comprising a fullerene or a fullerene derivative as electron transport material (ETM);
c) an intrinsic perovskite layer comprising at least one inorganic perovskite as absorber material; and
d) a doped p-type layer comprising a hole transport material (HTM) and at least one p-dopant;
wherein the n-type layer of the inorganic perovskite subcell is facing the front electrode.

Thus, according to the present invention in particular a device structure is disclosed, wherein the n-type layer (closer to the transparent front electrode) contains a fullerene, the photoactive layer (i-layer) contains an inorganic perovskite material, preferably an all-inorganic perovskite material, and the p-type layer contains an organic doped hole transport layer. Preferably the intrinsic perovskite layer is a photoactive layer, in particular a photoactive layer for absorbing light.

Preferably an n-type layer is an electron transport layer and a p-type layer is a hole transport layer, each might be n-doped or p-doped, respectively, which lead to an increase in density of free electrons or holes in the thermal equilibrium state. The i-layer (intrinsic layer) refers to an undoped layer which might be formed by a single material or a mixture of at least two materials.

In the context of the present invention a p-type layer is, in particular, a layer comprising a hole transport material (HTM) or a layer comprising a hole transport material (HTM) and a p-dopant. The p-type layer is in particular a hole transport layer (HTL) and favors the transport of positive charge carriers (holes) of a photoactive layer to an electrode and/or between two photoactive layers. Preferably the absolute value of the LUMO of the p-dopant should be at least equal to the absolute value of the HOMO of the corresponding p-type layer minus 0.2 eV or larger to allow for efficient p-doping.

In the context of the present invention an n-type layer is, in particular, a layer comprising an electron transport material (ETM) or a layer comprising an electron transport material (ETM) and an n-dopant. The n-type layer is in particular an electron transport layer (ETL). Preferably the absolute value of the HOMO of the n-dopant should be at least equal to the absolute value of the LUMO of the corresponding n-type layer plus 0.2 eV or smaller to allow for efficient n-doping. HOMO- and LUMO-energy levels can be determined from the redox potentials of the molecules, for which measurement methods are sufficiently described in the literature, e.g. by Cyclovoltammetry, as described by Lucia Leonat et al. (U.P.B. Sci. Bull., Series B, Vol. 75, Iss. 3, 2013). Alternatively, HOMO and LUMO energies or the corresponding ionization energies and electron affinities can be determined from photoelectron spectroscopy and inverse photoelectron spectroscopy. HOMO- and LUMO-energy levels were calculated alternatively based on the B3LYP method of the program Gaussian 98 (Gaussian, Inc., Pittsburgh, PA). The base set of the B3LYP method was defined as MIDI! for all available atoms and 6-31G* for all remaining atoms. The relative HOMO values calculated in this way were related to the material N,N'-Diphenyl-N,N-bis(3-methylphenyl)-1,1'-biphenyl-4,4'-diamine (TPD) studied in the literature (C. Adachi et al, Appl. Phys. Lett. 66, 2679-2681 (1995)). Fullerene C60 has an electron affinity of 4.0 eV (W. Zhao, A. Kahn, Charge transfer at n-doped organic-organic heterojunctions, J. Appl. Phys., 105 (12) (2009) 123711).

Preferably the transparent front electrode is indium tin oxide (ITO), fluorine doped tin oxide (FTO), indium zinc oxide, InZnAlO, ZnAlO, a conductive nanotube, a conductive nanoparticle, cadmium oxide, zirconium indium oxide, gallium zinc oxide, graphene, graphene oxide, graphite, carbon nanotube, carbon, Ag, Al, Au, Mo, Cu, Ni, Ca, Li, poly(3,4-ethylenedioxythiophene) polystyrene sulfonate (PEDOT:PSS) or a combination thereof.

In the context of the present invention a photoactive layer is a layer which actively contributes as an absorber layer by absorption of light and converting into electrical energy. In this context the term photoactive is understood to mean the conversion of light energy to electrical energy, e.g. the optoelectronic component converts light energy to electrical energy.

The inorganic perovskite subcell for an optoelectronic component according to the present invention and the process for manufacturing such an inorganic perovskite subcell according to the present invention have advantages in comparison with the prior art. Advantageously processing of the layers of the inorganic perovskite subcell at low substrate temperature is possible. Advantageously the perovskite structure is already formed during deposition without further post annealing after deposition of the perovskite layer. Advantageously, the inorganic perovskite subcell, preferably an all-inorganic perovskite subcell, in particular all layers of the perovskite subcell, can be processed by vacuum deposition, wherein processing at low substrate temperature is possible. Advantageously, annealing at low temperature is sufficient or even no annealing step is required. Advantageously, omitting any thermal annealing step considerably simplifies the process. Advantageously the inventive stack architecture allows processing of all-inorganic perovskites on a flexible PET substrate. Advantageously, the inorganic perovskite subcell can be a part of a flexible optoelectronic component, in particular a photovoltaic element, wherein the substrate has limited thermal stability up to 150°C, or below, like PET. Surprisingly it is not required to apply a thermal annealing step to achieve high fill factor FF and efficiency (PCE). Thus, it is possible to use a polymeric substrate with limited thermal stability, e.g. PET. Advantageously, the optoelectronic component comprising the inorganic perovskite subcell can be manufactured by roll-to-roll process by vacuum deposition on a substrate, in particular a flexible substrate. Advantageously, tandem cells comprising an inorganic perovskite subcell and an organic subcell can be processed by vacuum deposition in the same equipment.

According to a development of the invention, the at least one inorganic perovskite is an all-inorganic perovskite, preferably a three-dimensional halide perovskite, a double perovskite, or a combination thereof. Preferably the three-dimensional halide perovskite having a formula ABX₃, wherein A is selected from Cs, Na, K, Rb, or a combination thereof; B is selected from Pb, Sn, Ge, Cu, Fe, Ga, Eu, Sr, Ti, Mn, Bi, Zn, Mg, Ca, Ba, Y, Yb, Co, In, Sb, Bi, Ag, Ni, Ho, Er, Tb, Sm, La, or a combination thereof; and X is selected from F, Cl, Br, I, or a combination thereof. Preferably the double perovskite having a formula A₂BCX₆, wherein A is selected from Cs, Rb, or combination thereof; B is selected from Cu, Ag, Hg, Au, or a combination thereof; C is selected from Sb, Bi, In or a combination thereof; and X is selected from F, Cl, Br, I, or a combination thereof.

According to a development of the invention, the inorganic perovskite of the intrinsic perovskite layer is selected from the group consisting of CsPbI₃, CsPbBrI₂, CsPbBr₂I, CsPbBr₃, CsPbCl₂I, CsPbClI₂, CsPbCl₃, CsPbBr₂Cl, CsPbBrCl₂, and CsPbBrClI, or mixtures thereof.

In a preferred embodiment in the inorganic perovskite a halogen can be present in excess by at maximum of 20 % relatively to the stoichiometric ratio of the halogens to each other, preferably at maximum of 10 %, preferably at maximum of 5 %, preferably at maximum of 2 %, or preferably at maximum of 1 %.

According to a development of the invention, the intrinsic perovskite layer is directly arranged at the n-type layer.

According to a development of the invention, the n-type layer is an intrinsic n-type layer, wherein preferably the layer thickness of the intrinsic n-type layer is 10 nm to 50 nm, preferably 10 nm to 30 nm.

In a preferred embodiment the layer thickness of the p-type layer is 10 nm to 50 nm, preferably 10 nm to 30 nm.

According to a development of the invention, the fullerene or a fullerene derivative of the n-type layer is selected from the group consisting of C60, C70, C76, C80, C82, C84, C86, C90 und C94, or a derivative thereof, wherein the derivative preferably is a halogenated fullerene, a hydroxylated fullerene, a carboxylated fullerene, or an aminated fullerene, preferably the fullerene is C60, C70 and/or a derivative thereof, more preferably fullerene C60.

In a preferred embodiment the n-type layer is a non-doped n-type layer, preferably consisting of an electron transport material (ETM). In a more preferred embodiment the n-type layer consists of a fullerene or a fullerene derivative, preferably fullerene C60.

According to a development of the invention, the inorganic perovskite subcell further comprises in sequence of the layers an n-doped n-type layer before the n-type layer, preferably the intrinsic n-type layer, wherein preferably the n-type layer is directly arranged at the n-doped n-type layer.

According to a development of the invention, the ratio of the p-dopant of the doped p-type layer is at maximum 30 wt.-%, preferably at maximum 20 wt.-%, or preferably at maximum 10 wt.-%.

According to a development of the invention, an intrinsic p-type layer comprising at least one hole transport material (HTM) is arranged between the intrinsic perovskite layer and the doped p-type layer, wherein preferably the hole transport material (HTM) of the intrinsic p-type layer is an organic material. Preferably the p-type layer is a non-doped p-type layer, preferably hole transport material (HTM).

According to a development of the invention, the hole transport material (HTM) of the doped p-type layer and/or the intrinsic p-type layer is an organic material, and/or the p-dopant of the doped p-type layer is an organic p-dopant, preferably the p-dopant has a LUMO more negative than -4.0 eV, preferably more negative than -4.5 eV, preferably more negative than -4.7 eV, or preferably more negative than -5.0 eV.

In a preferred embodiment of the present invention the electron affinity of the p-dopant is at least 4.6 eV, preferably at least 4.8 eV, preferably at least 5.0 eV, or preferably at least 5.2 eV.

In a preferred embodiment the hole transport material (HTM) of the p-type layer is selected from the group consisting of N4,N4,N4',N4'-Tetra[(1,1'-biphenyl)-4-yl]-(1,1'-biphenyl)-4,4'-diamine (BPBPA), N4,N4,N4'',N4''-tetra([1,1'-biphenyl]-4-yl)-[1,1':4',1"-terphenyl]-4,4"-diamine (TaTm), N,N'-Bis(naphthalen-1-yl)-N,N'-bis(phenyl)-benzidine (a-NPD), MeO-TAD, Spiro-MeO-TAD, TDATA-Derivative, N4,N4'-Bis(9,9-dimethyl-9H-fluoren-2-yl)-N4,N4'-diphenylbiphenyl-4,4'-diamine (BF-DPB), and N3,N3`-Di(biphenyl(-4-yl)-N3,N3`-dimesitylbiphenyl-3,3`-diamin (HT3).

According to a development of the invention, the intrinsic perovskite layer has a layer thickness of 50 nm to 500 nm, preferably 50 nm to 400 nm, preferably 50 nm to 300 nm, preferably 100 to 500 nm, preferably 100 nm to 400 nm, preferably 100 to 300 nm, preferably 100 nm to 200 nm, preferably 150 nm to 300 nm, or preferably 200 nm to 500 nm.

In a preferred embodiment the front electrode is arranged at a light-facing side of the optoelectronic component as intended. In a preferred embodiment the back electrode is arranged at a light-facing away side of the optoelectronic component as intended. In a preferred embodiment the p-type layer of the inorganic perovskite subcell is facing the back electrode.

In a preferred embodiment the stack comprises a second photoactive layer, wherein the second photoactive layer is a perovskite photoactive layer comprising at least one perovskite absorber material, or an organic photoactive layer comprising at least one donor and at least one acceptor as organic absorber materials forming a donor/acceptor heterojunction, preferably the second photoactive layer is part of a second subcell, wherein the second subcell is preferably a BHJ, BHJ2, BHJ+, PHJ, or PHJ-cascade cell. In the context of the present invention a BHJ² cell is an organic sub-cell comprising two donor-acceptor blended layers directly attached to each other, wherein the two layers differ at least in the donor-material or the acceptor-material. In the context of the present invention a BHJ+ cell is an organic sub-cell comprising a donor-acceptor blended layer and directly attached at least one intrinsic donor or one intrinsic acceptor layer. In the context of the present invention a PHJ (planar heterojunction) cell is an organic sub-cell comprising an intrinsic acceptor layer and an intrinsic donor layer directly attached to each other. In the context of the present invention a PHJ-cascade cell is an organic subcell comprising an acceptor layer directly attached to at least two donor layers having different potentials, or a donor layer directly attached to at least two acceptor layers having different potentials. In a preferred embodiment the second photoactive layer is formed as planar heterojunction (PHJ), or the second photoactive layer is formed as bulk heterojunction (BHJ).

According to a development of the invention, the optoelectronic component is a single-junction, tandem-, or multi-junction device, wherein preferably in the tandem- or multijunction device at least one further subcell comprises an organic photoactive layer having a small band-gap, wherein at least one donor and at least one acceptor absorber material are forming a donor/acceptor heterojunction. A tandem cell is, in particular, an electronic component consisting of a vertical layer system of two cells connected in series. Correspondingly, a multijunction cell is, in particular, an electronic component consisting of a vertical layer system of several cells connected in series.

In a preferred embodiment the inorganic perovskite subcell can be combined with an organic subcell, preferably based on organic absorber materials, in an optoelectronic component in a tandem- or multijunction device. Also in combination with other PV materials like e.g. silicon based in a tandem or multijunction device, this stack may be advantageous due to the absence of a thermal annealing step.

In a preferred embodiment of the tandem- or multijunction device the perovskite subcell and the organic subcell are interconnected by an interconnecting unit. An interconnecting unit is understood to mean, in particular, a layer or a layer sequence between two photoactive layers or two subcells each comprising a photoactive layer, which connects the photoactive layers in series.

In a preferred embodiment the interconnecting unit comprises a p-type layer, preferably a p-doped p-type layer, and an n-type layer, preferably an n-doped n-type layer, arranged between the perovskite photoactive layer and the organic photoactive layer.

In a preferred embodiment the inorganic perovskite subcell is located at a side facing the light within the stack of the optoelectronic component as intended, preferably arranged at the front electrode, and the organic subcell is located at a side facing away from the light within the stack of the optoelectronic component as intended, preferably arranged at the back electrode.

In a preferred embodiment the further subcell comprises an organic photoactive layer having a small band-gap comprising at least one donor and at least one acceptor as organic absorber materials forming a donor/acceptor heterojunction, wherein the at least one donor of the organic photoactive layer is a A-D-A compound and/or a BODIPY compound. In the context of the present invention the wide band-gap of the perovskite photoactive layer is larger compared to the small band-gap of the organic photoactive layer. Thus, an organic subcell is combined with a perovskite subcell to form a tandem cell or a multijunction cell benefiting from their complementary band-gaps.

In the context of the present invention, a BODIPY compound refers to a compound derived from a core structure of general formula C₉H₇BN₂F₂, in particular a compound having a Bor-Difluorid-group having a Dipyrromethen-group, more particular a compound derived from 4,4-Difluoro-4-bora-3a,4a-diaza-s-Indacene.

In the context of the present invention, an A-D-A compound or an A-D-A-oligomer refers to a conjugated acceptor-donor-acceptor-oligomer (A-D-A') having a first acceptor-unit (A) and a second acceptor-unit (A'), each bound to the donor-unit (D). In a preferred embodiment the A-D-A compound is:
a conjugated Acceptor-Donor-Acceptor-Oligomer (A-D-A'-Oligomer) with an acceptor unit (A) and a further acceptor unit (A'), each bound to a donor unit (D), wherein the donor unit (D) is an extended donor unit, wherein the donor unit (D) comprises at least two monomers and/or at least 8 atoms having a common conjugated π-electron-system, which are formed from at least one atom selected from the group consisting of C, N, B, P, S, Si and O; or a conjugated Acceptor-Donor-Acceptor-Oligomer (A-D-A'-Oligomer) with a acceptor unit (A) and a further acceptor unit (A'), each bound to a donor unit (D), wherein the acceptor unit (A) and a further acceptor unit (A') each are an extended acceptor unit, wherein the acceptor unit (A) and the further acceptor unit (A') each comprises at least two monomers and/or at least 8 atoms having a common conjugated **π**-electron-system, which are formed from at least one atom selected from the group consisting of C, N, B, P, S, Si and O; or a conjugated Acceptor-Donor-Acceptor-Oligomer (A-D-A'-Oligomer) with a acceptor unit (A) and a further acceptor unit (A'), each bound to a donor unit (D), wherein either at least the donor unit (D) is an extended donor unit or at least the acceptor unit (A) and a further acceptor unit (A') each are an extended acceptor unit, wherein in case of an extended structure the donor unit (D), the acceptor unit (A) and the further acceptor unit (A') comprise at least two monomers and/or at least 8 atoms having a common conjugated **π**-electron-system, which are formed from at least one atom selected from the group consisting of C, N, B, P, S, Si and O.

In a preferred embodiment the at least one donor of the organic photoactive layer is a small molecule having a defined molecular structure and a molar mass of 100 g/mol to 1200 g/mol, preferably 100 g/mol to 1000 g/mol, or preferably 100 g/mol to 800 g/mol. In the context of the present invention 'small molecules' are, in particular, understood to be non-polymeric organic molecules having a defined molecular structure and a defined molar mass. Such "small molecules" are free of undefined, possible reactive groups at the end of the molecular chain and show ability to vaporize in vacuum and the associated possibility of purification by gradient sublimation, as a result layers comprising small molecules can be deposited by vacuum deposition.

In a preferred embodiment the wide band-gap of the perovskite photoactive layer is more than 1.7 eV, preferably more than 1.8 eV, or preferably more than 1.9 eV, and/or the small band-gap of the organic photoactive layer is less than 1.6 eV, preferably less than 1.4 eV, or preferably less than 1.2 eV, and/or the wide band-gap of the perovskite photoactive layer is at least 0.2 eV, preferably at least 0.3 eV, or preferably at least 0.4 eV, larger compared to the small band-gap of the organic photoactive layer.

In a preferred embodiment the perovskite photoactive layer absorbs at least in the blue-green spectral range, preferably at least in the blue-green-red spectral range, preferably in a range from 400 nm to 700 nm, more preferably in a range from 400 nm to 650 nm, and the organic photoactive layer absorbs at least in the red and near infrared spectral range, preferably in a range from 600 nm to 2500 nm, more preferably in a range from 600 nm to 1000 nm.

In a preferred embodiment the perovskite subcell comprises the following layer sequence arranged at the front electrode: intrinsic n-type layer/perovskite photoactive layer/intrinsic p-type layer, or n-doped n-type layer/intrinsic n-type layer/perovskite photoactive layer/intrinsic p-type layer/p-doped p-type layer.

In a preferred embodiment the perovskite subcell comprises the following layer sequence arranged at the front electrode: intrinsic n-type layer/perovskite photoactive layer/intrinsic p-type layer/p-doped p-type layer, or n-doped n-type layer/intrinsic n-type layer/perovskite photoactive layer/intrinsic p-type layer.

In a preferred embodiment the molecular weight of the n-type material, in particular the electron transport material (ETM) and/or the n-dopant, is at maximum 1500 g/mol, preferably at maximum 1000 g/mol. Preferably the n-dopant of the n-type layer is an organic n-dopant, preferably selected from the group consisting of 2,2'-Diisopropyl-1,1',3,3'-tetramethyl-2,2',3,3',4,4',5,5',6,6',7,7'-dodecahydro-2,2'- bibenzo[d]imidazol (NDR-1); 4,4',5,5'-Tetracyclohexyl-1,1',2,2',3,3'-hexamethyl-2,2',3,3'-tetrahydro-2,2'-biimidazol (NDR-2); 2,2'-diisopropyl-4,4',5,5'-tetrakis(2-methoxyphenyl)-1,1',3,3'-tetramethyl-2,2',3,3'-tetrahydro-1H,1'H-2,2'-biimidazol (NDR-3); 2,2'-diisopropyl-1,1',3,3'-tetramethyl-2,2',3,3'-tetrahydro-1H,1'H-2,2'-bibenzo[d]imidazol (NDR-4); 2,2'-diisopropyl-4,4',5,5'-tetrakis(3-methoxyphenyl)-1,1',3,3'-tetramethyl-2,2',3,3'-tetrahydro-1H,1'H-2,2'-biimidazol (NDR-5); 2-Isopropyl-1,3-dimethyl-2,3,6,7-tetrahydro-5,8-dioxa-1,3-diaza-cyclopenta[b]naphthene; Bis-[1,3-dimethyl-2-isopropyl-1,2-dihydro-benzimidazolyl-(2)]; 2,2'-Diisopropyl-4,5-bis (2-methoxyphenyl)-4',5'-bis(4-methoxyphenyl)-1,1',3,3'-tetramethyl-2,2',3,3'-tetrahydro-2,2'-biimidazol; and NDN45.

In a preferred embodiment the molecular weight of the p-type material is at maximum 1500 g/mol, preferably at maximum 1000 g/mol. Preferably the p-dopant of the p-type layer is selected from the group consisting of 2,2'-(perfluorocyclohexa-2,5-diene-1,4-diylidene)dimalononitril (TCNQ-1), N'-Dicyan-2,3,5,6-tetrafluoro-1,4-chinondiimin; N,N'-Dicyan-2,5-dichloro-1,4-chinondiimin, N,N'-Dicyan-2,5-dichloro-3,6-difluoro-1,4-chinondiimin, N,N'-Dicyan-2,3,5,6,7,8-hexafluoro-1,4-naphthochinondiimin, 1,4,5,8-Tetrahydro-1,4,5,8-tetrathia-2,3,6,7-tetracyano-anthrachinon, 1,3,4,5,7,8-Hexafluoronaphtho-2,6-chinontetracyanomethan (TCNQ-7), 2,2'-(2,5-Dibrom-3,6-difluorcyclobexa-2,5-dien-1,4-diyliden)dimalononitril, 4,4'-(1E,1'E)-(2-cyano-3,6-difluoro-5-isocyanocyclohexa-2,5-diene-1,4-diylidene)bis-(cyanomethan-1-yl-1-ylidene)bis(2,3,5,6-tetrafluorobenzonitril), 2,2',2"- (Cyclopropan-1,2,3 - triyliden)tris(2-(2,6-dichlor-3,5-difluor-4-(trifluormethyl)phenyl)acetonitril), (2E,2'E,2"E)-2,2',2"-(cyclopropane-1,2,3-triylidene)tris(2-(perfluorophenyl)acetonitril), 2,2',2"-(cyclopropane-1,2,3-triylidene)tris(2-(perfluorobiphenyl-4-yl)acetonitril), 2,2',2"-(cyclopropane-1,2,3-triylidene)tris(2-(2,6-dichloro-3,5-difluoro-4-(trifluoromethyl)phenyl)-acetonitril), and Benzeneacetonitril, α,α',α"-1,2,3-cyclopropanetriylidenetris[4-cyano-2,3,5,6-tetrafluoro-(PR-1), 2,3,5,6-Tetrafluoro-7,7,8,8-tetracyanoquinodimethane (F4TCNQ), 2,2'-(1,3,4,5,7,8-Hexafluoro-2,6-naphthalenediylidene)bis-propanedinitrile (F6TCNNQ), and NDP9.

In a preferred embodiment the optoelectronic component is flexible. A flexible optoelectronic component is understood to mean, in particular, an optoelectronic component which is bendable and/or extensible in a specific region. In a preferred embodiment the substrate is flexible and/or the stack of the optoelectronic component is flexible.

In a preferred embodiment the optoelectronic component is a photovoltaic element, preferably a flexible photovoltaic element.

The underlying technical problem of the present invention is also solved by providing a process for manufacturing an inorganic perovskite subcell of an optoelectronic component, preferably a photovoltaic element, in particular according to any of the previously described embodiments, by vacuum deposition on a substrate, wherein the inorganic perovskite subcell having a n-i-p cell architecture. This in particular results in advantageous effects of the process as already previously described in the context of the optoelectronic component according to the present invention. The process comprising the following steps: ii) applying an n-type layer by evaporating a fullerene or a fullerene derivative as electron transport material (ETM); iii) applying an intrinsic perovskite layer comprising at least one inorganic perovskite as absorber material by co-evaporating of at least a first precursor and a second precursor, wherein the first precursor and the second precursor are each independently selected from the group consisting of CsCl, CsBr, CsI, PbCl₂, PbBr₂, and PbI₂; iv) applying a doped p-type layer by co-evaporating a hole transport material (HTM) and at least one p-dopant; and v) obtaining the inorganic perovskite subcell of the optoelectronic component. Preferably all layers of the stack are applied by vacuum deposition.

In a preferred embodiment no annealing is carried out during or after the process.

In a preferred embodiment the process is carried out at a temperature from 20°C to 120°C, preferably from 20°C to 80°C, preferably from 20°C to 60°C, or preferably from 20°C to 40°C.

According to a development of the invention, the temperature of the substrate is from 20°C to 120°C, preferably from 20°C to 80°C, preferably from 20°C to 60°C, or preferably from 20°C to 40°C.

In a preferred embodiment a substrate with a transparent front electrode is provided in a step i) before step ii), wherein the n-type layer is applied on the substrate with the transparent front electrode directly or with an n-doped n-type layer in between.

In a preferred embodiment in a step ii1) an n-doped n-type layer is applied by vacuum-deposition before step ii).

In an alternative preferred embodiment a substrate with a transparent front electrode is provided in step i) before step ii), wherein a further subcell is applied between the substrate with the transparent front electrode and the inorganic perovskite subcell after step i) and before step ii).

In a preferred embodiment in a step vi) after step v) a back electrode is applied on the doped p-type layer, wherein the optoelectronic component is obtained after step vi).

According to a development of the invention, at maximum a thermal annealing of the intrinsic perovskite layer c) is carried out during or after step iii) at a temperature from 20°C to 120°C, preferably from 20°C to 80°C, preferably from 20°C to 60°C, preferably from 20°C to 50°C, preferably from 20°C to 40°C, or preferably from 20 to 30°C, or no thermal annealing of the intrinsic perovskite layer c) is carried out during or after applying the intrinsic perovskite layer c) in step iii), more particular without annealing at all.

In the context of the present invention annealing, preferably thermal annealing, is in particular understood to mean a thermal treatment process in which at least a layer to be annealed is heated for a short period of time, preferably for a period of a few seconds to a few minutes. In particular, the annealing is a heat treatment that alters the physical and/or chemical properties of a material. In particular the annealing alters the crystal structure, the morphology and/or the crystallinity of the inorganic perovskite layer.

In a preferred embodiment the annealing at a defined temperature is carried out over a period of time of at least 1s, preferably at least 10s, preferably at least 20s, preferably at least 30s, preferably at least 60s, preferably at least 2 min, preferably at least 5 min, or preferably at least 10 min, or in a range of 1s to 10 min, preferably 1s to 60s, preferably 1s to 10s, or preferably 60s to 10 min.

According to a development of the invention, after step iii) and before step iv) in an additional step iv1) an intrinsic p-type layer is applied by vacuum deposition of a hole transport material (HTM).

According to a development of the invention, the substrate is formed by a film or comprises a film, preferably the film is formed by a polymer layer. In a preferred embodiment the substrate is a film, in particular a film having a limited thermal stability, preferably up to 150°C, preferably up to 130°C, preferably up to 120°C, preferably up to 110°C, or preferably up to 100°C.

In a preferred embodiment, the film is formed by a polymer layer, preferably the polymer layer is selected from the group consisting of ethylene tetrafluoroethylene (ETFE), polyethylene terephthalate (PET), polyolefin, polyetheretherketone (PEEK), polymethyl methacrylate (PMMA), polypropylene (PP), polyethylene (PE), polyethylene naphthalate (PEN), ethylene vinyl acetate (EVA), polyacrylate (PA), polycarbonate (PC), and thermoplastic polyurethane (TPU).

According to a development of the invention, the substrate is flexible.

In a preferred embodiment the process is carried out in a roll-to-roll fashion.

### Description of the Drawings

The invention is described in more detail with reference to working examples and figures. The working examples are intended to describe the invention without restricting it. It can be demonstrated that the specific structure of an inorganic perovskite subcell of the present invention allows for processing the optoelectronic component at low temperatures, in particular without thermal annealing.

In all figures, identical and functionally identical elements are provided with the same reference signs, so that in this respect reference is made to the preceding description. The layer thicknesses and the ratio of the layer thicknesses to each other do not correspond to the actual dimensions.
Fig. 1 shows a schematic illustration of an exemplary embodiment of an optoelectronic component with an inorganic perovskite subcell in cross-section;
Fig. 2 shows a schematic illustration of an exemplary embodiment of an optoelectronic component with an inorganic perovskite subcell in cross-section;
Fig. 3 shows a schematic illustration of an exemplary embodiment of an optoelectronic component with an inorganic perovskite subcell and an organic subcell in cross-section;
Fig. 4 shows in several embodiments a current-voltage curve of an optoelectronic component formed as single-junction comprising an inorganic perovskite subcell; and
Fig. 5 shows current-voltage curves of an optoelectronic component with an inorganic perovskite subcell constructed as n-i-p structure and as p-i-n structure.

### Working examples

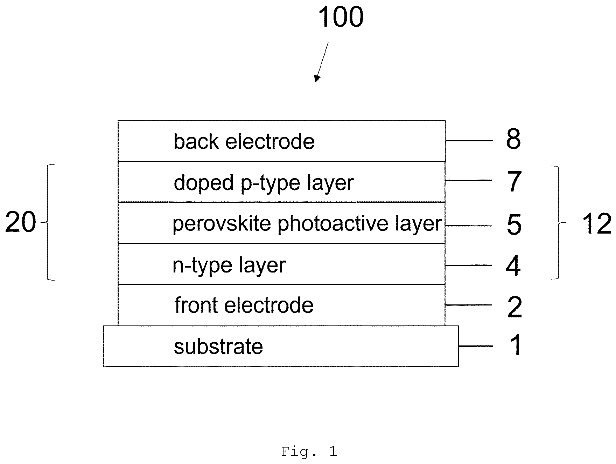

Fig. 1 shows a schematic illustration of an exemplary embodiment of an optoelectronic component 100 with an inorganic perovskite subcell 12 in cross-section.

The optoelectronic component 100 comprises a transparent front electrode 2, a back electrode 8, and a stack 20 arranged between the front electrode 2 and the back electrode 8, the stack 20 comprising an inorganic perovskite subcell 12. The inorganic perovskite subcell 12 having a n-i-p cell architecture comprising in sequence the following layers: b) an n-type layer 4 comprising a fullerene or a fullerene derivative as electron transport material (ETM); c) an intrinsic perovskite layer 5 comprising at least one inorganic perovskite as absorber material; and d) a doped p-type layer 7 comprising a hole transport material (HTM) and at least one p-dopant; wherein the n-type layer 4 of the inorganic perovskite subcell 12 is facing the front electrode 2.

In particular, this n-i-p cell architecture allows manufacturing of inorganic perovskite subcells 12 of optoelectronic components 100 at low temperature, in particular without an additional annealing step, while the efficiency of the optoelectronic component 100 is not significantly reduced. In this example the optoelectronic component 100 is a photovoltaic element.

In this exemplary embodiment the intrinsic perovskite layer 5 is directly arranged at the n-type layer 4.

In a further embodiment of the invention the at least one inorganic perovskite is an all-inorganic perovskite, preferably a three-dimensional halide perovskite, a double perovskite, or a combination thereof, wherein preferably the three-dimensional halide perovskite having a formula ABX₃, wherein A is selected from Cs, Na, K, Rb, or a combination thereof; B is selected from Pb, Sn, Ge, Cu, Fe, Ga, Eu, Sr, Ti, Mn, Bi, Zn, Mg, Ca, Ba, Y, Yb, Co, In, Sb, Bi, Ag, Ni, Ho, Er, Tb, Sm, La, or a combination thereof; and X is selected from F, Cl, Br, I, or a combination thereof; and wherein preferably the double perovskite having a formula A₂BCX₆, wherein A is selected from Cs, Rb, or combination thereof; B is selected from Cu, Ag, Hg, Au, or a combination thereof; C is selected from Sb, Bi, In or a combination thereof; and X is selected from F, Cl, Br, I, or a combination thereof.

In a further embodiment of the invention the inorganic perovskite of the intrinsic perovskite layer 5 is selected from the group consisting of CsPbI₃, CsPbBrI₂, CsPbBr₂I, CsPbBr₃, CsPbCl₂I, CsPbClI₂, CsPbCl₃, CsPbBr₂Cl, CsPbBrCl₂, and CsPbBrClI, or mixtures thereof.

In a further embodiment of the invention the n-type layer 4 is an intrinsic n-type layer 4, wherein preferably the layer thickness of the intrinsic n-type layer 4 is 10 nm to 50 nm, preferably 10 nm to 30 nm.

In a further embodiment of the invention the fullerene or a fullerene derivative of the n-type layer 4 is selected from the group consisting of C60, C70, C76, C80, C82, C84, C86, C90 und C94, or a derivative thereof, wherein the derivative preferably is a halogenated fullerene, a hydroxylated fullerene, a carboxylated fullerene, or an aminated fullerene, preferably the fullerene is C60, C70 and/or a derivative thereof, more preferably fullerene C60.

In a further embodiment of the invention the ratio of the p-dopant of the doped p-type layer is at maximum 30 wt.-%, preferably at maximum 20 wt.-%, or preferably at maximum 10 wt.-%.

In a further embodiment of the invention the intrinsic perovskite layer 5 has a layer thickness of 50 nm to 500 nm, preferably 50 nm to 400 nm, preferably 50 nm to 300 nm, preferably 100 to 500 nm, preferably 100 nm to 400 nm, preferably 100 to 300 nm, preferably 100 nm to 200 nm, preferably 150 nm to 300 nm, or preferably 200 nm to 500 nm.

In this exemplary embodiment the optoelectronic component 100 is a single-junction device, wherein the single-junction is implemented by the perovskite subcell 12.

The individual layers of the stack 20 and the electrodes 2,8 of the optoelectronic component 100 can be produced by vacuum deposition of the compounds on the substrate 1. The substrate 1 can be a flexible substrate 1, e.g. a film from PET. The layers can be deposited in a roll-to-roll process.

The process for manufacturing an inorganic perovskite subcell 12 of an optoelectronic component 100 by vacuum deposition on a substrate 1, wherein the inorganic perovskite subcell 12 having a n-i-p cell architecture, comprises the following steps:
ii) applying an n-type layer 4 by evaporating a fullerene or a fullerene derivative as electron transport material (ETM); iii) applying an intrinsic perovskite layer 5 comprising at least one inorganic perovskite as absorber material by co-evaporating of at least a first precursor and a second precursor, wherein the first precursor and the second precursor are each independently selected from the group consisting of CsCl, CsBr, CsI, PbCl₂, PbBr₂, and PbI₂; iv) applying a doped p-type layer 7 by co-evaporating a hole transport material (HTM) and at least one p-dopant; and v) obtaining the inorganic perovskite subcell 12 of the optoelectronic component 100.

In a further embodiment of the invention the temperature of the substrate 1 is from 20°C to 120°C, preferably from 20°C to 80°C, preferably from 20°C to 60°C, or preferably from 20°C to 40°C.

In a further embodiment of the invention at maximum a thermal annealing of the intrinsic perovskite layer 5 is carried out during or after step iii) at a temperature from 20°C to 120°C, preferably from 20°C to 80°C, preferably from 20°C to 60°C, preferably from 20°C to 50°C, preferably from 20°C to 40°C, or preferably from 20 to 30°C, or no thermal annealing of the intrinsic perovskite layer 5 is carried out during or after applying the intrinsic perovskite layer 5 in step iii).

In a further embodiment of the invention after step iii) and before step iv) in an additional step iv1) an intrinsic p-type layer 6 is applied by vacuum deposition of a hole transport material (HTM).

In a further embodiment of the invention the substrate 1 comprises a film, preferably the film is formed by a polymer layer, wherein preferably the substrate 1 is flexible.

In a working example the perovskite subcell 12 of the photovoltaic element is manufactured as follows: The perovskite subcell 12 was manufactured by thermal evaporation processes in chambers kept under high vacuum, typically at/below 10⁻⁷ mbar. Vacuum deposition of the individual layers of the stack 20 as well as the electrode 8 was used to manufacture the photovoltaic element. The substrate 1 with the front electrode 2 is provided. The layers of the stack 20 are formed step by step one after the other. In this working example, the perovskite subcell 12 is an all-inorganic CsPbI₂Br single junction perovskite cell. The perovskite subcell 12 is manufactured as n-i-p device.

A substrate 1 made from a PET film coated with ITO as front electrode 2 was loaded into a vacuum chamber. For the perovskite subcell 12, which is an all-inorganic CsPbI₂Br single junction perovskite cell, a layer of fullerene C60 (15 nm) was deposited at a deposition rate of 0.2 to 0.3 Å/s on the ITO (100 nm) coated PET film to create an n-type layer 4 as electron transport layer (ETL). An all-inorganic CsPbI₂Br perovskite photoactive layer 5 was subsequently formed on the n-type layer 4 by co-evaporating two precursors simultaneously, a first precursor CsBr and a second precursor PbI₂, at deposition rates of 0.2 Å/s and 0.31 Å/s, respectively. The substrate temperature was adjusted to 30°C. The thickness of the perovskite photoactive layer 5 was in a range of 100 to 400 nm. A layer of a hole transport material (HTM) N,N,N',N'-Tetra([1,1'-biphenyl]-4-yl)[1,1':4',1"-terphenyl]-4,4"-diamine (TaTm) (10 nm), or alternatively N4,N4'-Bis(9,9-dimethyl-9H-fluoren-2-yl)-N4,N4'-diphenylbiphenyl-4,4'-diamine (BF-DPB), was applied at a deposition rate of 0.3 Å/s on top of the perovskite photoactive layer 5 to form an intrinsic p-type layer 6 as hole transport layer (HTL). Subsequently by co-evaporating TaTm as HTM and NDP9 as p-dopant in a ratio of 10 wt.- % (30 nm) at a deposition rate of 1.0 Å/s a p-doped p-type layer 7 (p-HTL) was formed. Deposition of the layers at higher deposition rate or lower deposition rate is possible, preferably in the range of 0.1 to 10 Å/s. No annealing during the process and no post annealing was done. Finally, an Au metal was deposited at a rate of 1.0 Å/s to a thickness of 50 nm to form the back electrode 8. The temperature of the substrate 1 during the process was 30°C. In this example, the complete stack 20 including the electrode 8 was applied by vacuum deposition and processed in a roll-to-roll process.

In an alternative embodiment additionally an ultrathin layer of the p-dopant NDP9 (1 nm) was applied between the doped p-type layer 7 and the back electrode 8 to optimize the electrical contact between the doped p-type layer 7 and the back electrode 8.

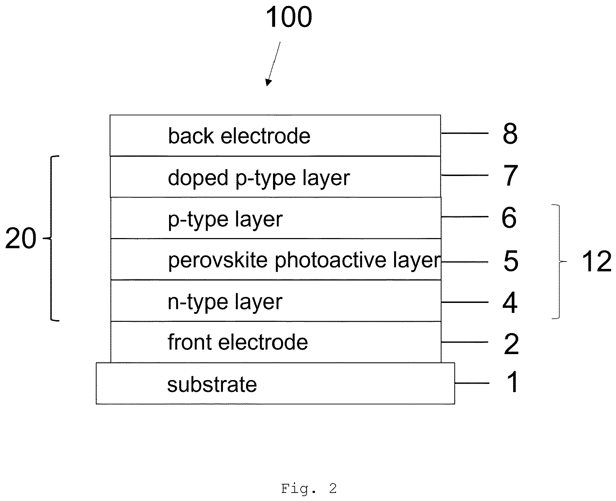

Fig. 2 shows a schematic illustration of an exemplary embodiment of an optoelectronic component 100 with an inorganic perovskite subcell 12 in cross-section. In this exemplary embodiment the optoelectronic component 100 is a photovoltaic element.

In this exemplary embodiment the stack 20 is essentially the same compared to Fig. 1 besides that additionally a p-type layer 6, in particular an intrinsic p-type layer 6, comprising at least one hole transport material (HTM) is applied between the intrinsic perovskite layer 5 and the doped p-type layer 7, wherein preferably the hole transport material (HTM) of the intrinsic p-type layer 6 is an organic material.

In a further embodiment of the invention the inorganic perovskite subcell 12 further comprises in sequence of the layers an n-doped n-type layer 3 before the n-type layer 4, preferably the intrinsic n-type layer 4, wherein preferably the n-type layer 4 is directly arranged at the n-doped n-type layer 3.

In a further embodiment of the invention the hole transport material (HTM) of the doped p-type layer 7 and/or the intrinsic p-type layer 6 is an organic material, and/or the p-dopant of the doped p-type layer 7 is an organic p-dopant, preferably the p-dopant has a LUMO more negative than -4.0 eV, preferably more negative than -4.5 eV, or preferably more negative than -5.0 eV.

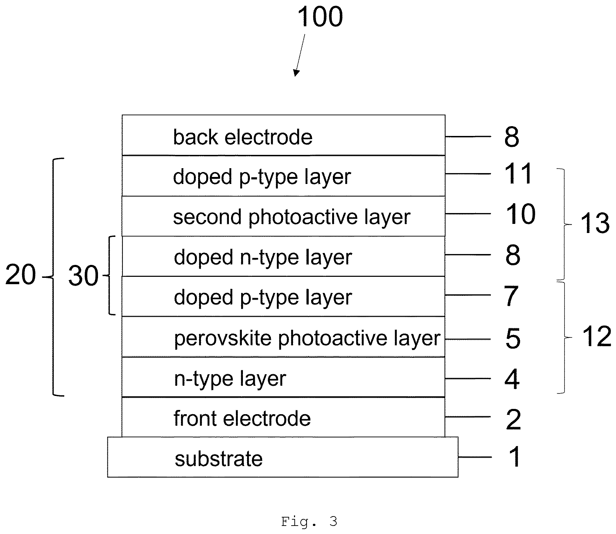

Fig. 3 shows a schematic illustration of an exemplary embodiment of an optoelectronic component 100 with an inorganic perovskite subcell 12 and an organic subcell 13 in cross-section. In this exemplary embodiment the optoelectronic component 100 is a photovoltaic element.

In this exemplary embodiment the stack 20 is substantially the same compared to Fig. 1, wherein the optoelectronic component 100 is formed as tandem cell comprising between the perovskite subcell 12 and the back electrode 8 a further subcell 13. The further subcell 13 comprises a doped n-type layer 8, a second photoactive layer 10, which is an organic photoactive layer, and a doped p-type layer 11. The perovskite subcell 12 and the further subcell 13 are interconnected by an interconnecting unit 30 formed by the doped p-type layer 7 and the doped n-type layer 8.

In a further embodiment of the invention the organic photoactive layer of the further subcell 13 having a small band-gap, wherein at least one donor and at least one 10 acceptor absorber material are forming a donor/acceptor heterojunction.

In an alternative embodiment of the invention the optoelectronic component 100 is a multi-junction device comprising the perovskite subcell 12 and at least two further subcells.

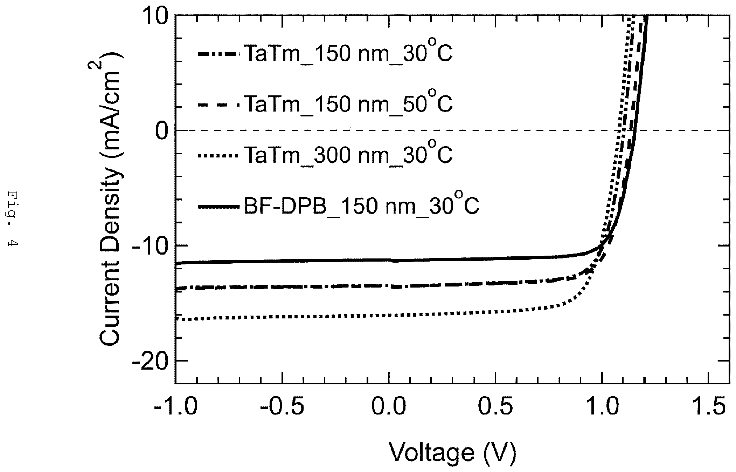

Fig. 4 shows in several embodiments a current-voltage curve of an optoelectronic component 100 formed as single-junction comprising an inorganic perovskite subcell 12. In this embodiment the optoelectronic component 100 is a photovoltaic element.

In first working examples the photovoltaic element comprises a substrate 1, in particular a flexible substrate 1, e.g. a PET film, alternatively a rigid substrate 1, e.g. glass, with transparent ITO (indium-tin-oxide) as front electrode 2. In an alternative embodiment the front electrode 2 can be formed of a metal, in particular Al, Ag, Au or a combination thereof, another conductive oxide, in particular ZnO:Al, or a conductive polymer, in particular PEDOT:PSS (Poly(3,4-ethylenedioxythiophene)-poly(sytrenesulfonate) or PANI (Polyanilin). On the front electrode 2 an n-doped n-type layer 3 (5 nm) of fullerene C60 doped with the n-dopant NDN45 (20 wt.-%) is arranged. The perovskite subcell 12 is formed by a layer of fullerene C60 as n-type layer 4 which is an electron transport layer (ETL), an intrinsic perovskite layer 5 as perovskite photoactive layer comprising an inorganic perovskite, e.g. CsPbI₂Br, and a p-type layer 6 of TaTm or BF-DPB. On top arranged is a p-doped p-type layer 7, e.g. TaTm doped with NDP9 (LUMO of -5.4 eV), and a back electrode 8 made of Au or Al. The stack 20 of such an optoelectronic component 100 is summarized in table 1. The perovskite subcell 12, formed as perovskite single junction, is constructed in a n-i-p cell architecture.

In the first working examples TaTm was used as HTM for the p-type layer 6 and the doped p-type layer 7 in examples 2A,2B,2C and BF-DPB in example 2D, the layer thickness of the perovskite photoactive layer 5 was 150 nm in examples 2A,2B,2D and 300 nm in example 2C, and the substrate temperature was 30°C in examples 2A,2C,2D and 50°C in example 2B.

The structure of the photovoltaic element of the first working examples is shown in table 1:

**Table 1**

| **layer** | **material** | **thickness** / **nm** |
|---|---|---|
| back electrode 8 | Au | 50 |
| p-dopant | NDP9 | 1 |
| p-doped p-type layer 7 | TaTm or BF-DPB /NDP9 (10 wt.-%) | 30 |
| p-type layer 6 | TaTm or BF-DPB | 10 |
| perovskite photoactive layer 5 | perovskite CsPbI₂Br | 100 to 400 |
| n-type layer 4 | C60 | 15 |
| n-doped n-type layer 3 | C60 /NDN45 (20 wt.-%) | 5 |
| front electrode 2 | ITO | 100 |
| substrate 1 | PET film | |

| | | |
|---|---|---|
| ITO: indium tin oxide NDP9: commercial p-dopant of Novaled GmbH TaTm: N,N,N',N'-Tetra([1,1'-biphenyl]-4-yl)[1,1':4',1"-terphenyl]-4,4"-diamine BF-DPB: N4,N4'-Bis(9,9-dimethyl-9H-fluoren-2-yl)-N4,N4'-diphenylbiphenyl-4,4'-diamine NDN45: commercial n-dopant of Novaled GmbH | | |

The current-voltage curves of the photovoltaic elements were measured using a Keithley 2400 source measure unit under AM1.5 sun simulator (AM = air mass; AM=1.5, radiant power 1000 W/m²) (Steuernagel SC1200).

The current-voltage curves of the photovoltaic elements are shown in Fig. 4. The parameters open-circuit voltage Voc, short-circuit current Jsc, fill factor FF, and the resulting cell performance (PCE) of the photovoltaic element are summarized in table 2.

**Table 2**

| Devices | Voc (V) | Jsc (mA/cm₂) | FF (%) | PCE (%) |
|---|---|---|---|---|
| 2A) CsPbI₂Br (TaTm, 30°C, 150 nm) | 1.1 | 13.4 | 75.8 | 11.2 |
| 2B) CsPbI₂Br (TaTm, 50°C, 150 nm) | 1.14 | 13.5 | 75.1 | 11.6 |
| 2C) CsPbI₂Br (TaTm, 30°C, 300 nm) | 1.08 | 16.0 | 73.1 | 12.6 |
| 2D) CsPbI₂Br (BF-DPB, 30°C, 150 nm) | 1.16 | 11.2 | 77.1 | 10.0 |

The elements comprising a perovskite subcell 12 of the present invention show a high fill factor of 73.1% to 77.1% and an efficiency (PCE) from 10.0% to 12.6%.

The experimental data demonstrate that the efficiency (PCE) of photovoltaic elements comprising an inorganic perovskite subcell 12 of the present invention is comparable or even improved compared to inorganic perovskite subcells from prior art even without annealing in the process for manufacturing. Therefore, processing on substrates which are sensitive to high temperatures is possible without detrimental effect on the substrate.

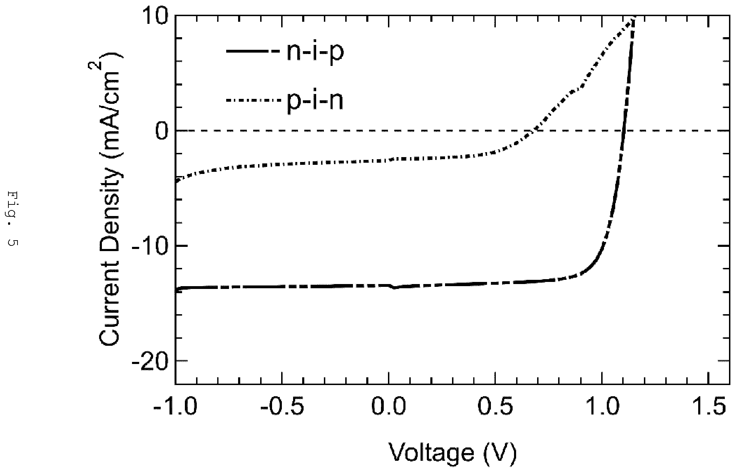

Fig. 5 shows current-voltage curves of an optoelectronic component 100 with an inorganic perovskite subcell 12 constructed as n-i-p structure and as p-i-n structure. In this embodiment the optoelectronic component 100 is a photovoltaic element.

In this exemplary embodiment an inventive photovoltaic element comprising an inorganic perovskite subcell 12 constructed as n-i-p structure was compared to a non-inventive photovoltaic element comprising an inorganic perovskite subcell constructed as p-i-n structure as comparative example.

The p-i-n device was manufactured by reversing the process for the n-i-p device as described for Fig. 1, starting with deposition of a p-doped p-type layer 7 and an intrinsic p-type layer 6 on a PET film coated with ITO as substrate.

The structure of the inventive photovoltaic element with the perovskite subcell 12 corresponds to example 2A of the first working example (Fig. 4, table 1). The structure of the photovoltaic element with the perovskite subcell constructed as pi-n structure in a comparative example is shown in table 3:

**Table 3**

| **layer** | **material** | **thickness / nm** |
|---|---|---|
| second electrode 8 | Au | 50 |
| doped n-type layer 3 | C60 / NDN45 (20 wt.-%) | 5 |
| n-type layer 4 | C60 | 15 |
| perovskite photoactive layer 5 | perovskite CsPbI₂Br | 150 |
| p-type layer 6 | TaTm (or BF-DPB) | 10 |
| p-doped p-type layer 7 | TaTm (or BF-DPB)/ NDP9 (10 wt.-%) | 30 |
| p-dopant | NDP9 | 1 |
| first electrode 2 | ITO | 100 |
| substrate 1 | PET film | |

| | | |
|---|---|---|
| ITO: indium tin oxide NDP9: commercial p-dopant of Novaled GmbH TaTm: N,N,N',N'-Tetra([1,1'-biphenyl]-4-yl)[1,1':4',1"-terphenyl]-4,4"-diamine BF-DPB: N4,N4'-Bis(9,9-dimethyl-9H-fluoren-2-yl)-N4,N4'-diphenylbiphenyl-4,4'-diamine NDN45: commercial n-dopant of Novaled GmbH | | |

The current-voltage curves of the n-i-p structure and the p-i-n structure are shown in Fig. 5.

The cell performance (PCE) of the inventive photovoltaic element comprising the inorganic perovskite subcell 12 constructed as n-i-p structure was 11.2% compared to the non-inventive photovoltaic element comprising an inorganic perovskite subcell constructed as p-i-n structure as comparative example of 0.9%.

Thus, it is demonstrated that the specific n-i-p structure of a perovskite subcell 12 of the present invention is superior compared to the corresponding p-i-n structure even without annealing at high temperatures in the manufacturing process of the perovskite subcell 12.

## Claims

1. An optoelectronic component (100), preferably a photovoltaic element, comprising a transparent front electrode (2), a back electrode (8), and a stack (20) arranged between the front electrode (2) and the back electrode (8), the stack (20) comprising an inorganic perovskite subcell (12),
**characterized in that** the inorganic perovskite subcell (12) having a n-i-p cell architecture comprising in sequence the following layers:
b) an n-type (4) layer comprising a fullerene or a fullerene derivative as electron transport material (ETM);
c) an intrinsic perovskite layer (5) comprising at least one inorganic perovskite as absorber material; and
d) a doped p-type layer (7) comprising a hole transport material (HTM) and at least one p-dopant;
wherein the n-type layer b) (4) of the inorganic perovskite subcell (12) is facing the front electrode (2).

2. Optoelectronic component (100) according to claim 1, wherein the at least one inorganic perovskite is an all-inorganic perovskite, preferably a three-dimensional halide perovskite, a double perovskite, or a combination thereof, wherein preferably the three-dimensional halide perovskite having a formula ABX₃, wherein A is selected from Cs, Na, K, Rb, or a combination thereof; B is selected from Pb, Sn, Ge, Cu, Fe, Ga, Eu, Sr, Ti, Mn, Bi, Zn, Mg, Ca, Ba, Y, Yb, Co, In, Sb, Bi, Ag, Ni, Ho, Er, Tb, Sm, La, or a combination thereof; and X is selected from F, Cl, Br, I, or a combination thereof; and wherein preferably the double perovskite having a formula A₂BCX₆, wherein A is selected from Cs, Rb, or combination thereof; B is selected from Cu, Ag, Hg, Au, or a combination thereof; C is selected from Sb, Bi, In or a combination thereof; and X is selected from F, Cl, Br, I, or a combination thereof.

3. Optoelectronic component (100) according to claim 1 or 2, wherein the inorganic perovskite a of the intrinsic perovskite layer c) (5) is selected from the group consisting of CsPbI₃, CsPbBrI₂, CsPbBr₂I, CsPbBr₃, CsPbCl₂I, CsPbClI₂, CsPbCl₃, CsPbBr₂Cl, CsPbBrCl₂, and CsPbBrClI, or mixtures thereof.

4. Optoelectronic component (100) according to any of the preceding claims, wherein the intrinsic perovskite layer c) (5) is directly arranged at the n-type layer b) (4).

5. Optoelectronic component (100) according to any of the preceding claims, wherein the n-type layer b) (4) is an intrinsic n-type layer b) (4), wherein preferably the layer thickness of the intrinsic n-type layer b) (4) is 10 nm to 50 nm, preferably 10 nm to 30 nm.

6. Optoelectronic component (100) according to any of the preceding claims, wherein the fullerene or a fullerene derivative of the n-type layer b) (4) is selected from the group consisting of C60, C70, C76, C80, C82, C84, C86, C90 und C94, or a derivative thereof, wherein the derivative preferably is a halogenated fullerene, a hydroxylated fullerene, a carboxylated fullerene, or an aminated fullerene, preferably the fullerene is C60, C70 and/or a derivative thereof, more preferably fullerene C60.

7. Optoelectronic component (100) according to any of the preceding claims, wherein the inorganic perovskite subcell (12) further comprises in sequence of the layers an n-doped n-type layer b1) (3) before the n-type layer b) (4), preferably the intrinsic n-type layer b) (4), wherein preferably the n-type layer b) (4) is directly arranged at the n-doped n-type layer b1) (3).

8. Optoelectronic component (100) according to any of the preceding claims, wherein the ratio of the p-dopant of the doped p-type layer (7) is at maximum 30 wt.-%, preferably at maximum 20 wt.-%, or preferably at maximum 10 wt.-%.

9. Optoelectronic component (100) according to any of the preceding claims, wherein an intrinsic p-type layer d1) (6) comprising at least one hole transport material (HTM) is arranged between the intrinsic perovskite layer c) (5) and the doped p-type layer d) (7), wherein preferably the hole transport material (HTM) of the intrinsic p-type layer d1) (6) is an organic material.

10. Optoelectronic component (100) according to any of the preceding claims, wherein the hole transport material (HTM) of the doped p-type layer c) (7) and/or the intrinsic p-type layer c1) (6) is an organic material, and/or the p-dopant of the doped p-type layer c) (7) is an organic p-dopant, preferably the p-dopant has a LUMO more negative than -4.0 eV, preferably more negative than -4.5 eV, or preferably more negative than -5.0 eV.

11. Optoelectronic component (100) according to any of the preceding claims, wherein the intrinsic perovskite layer c) (5) has a layer thickness of 50 nm to 500 nm, preferably 50 nm to 400 nm, preferably 50 nm to 300 nm, preferably 100 to 500 nm, preferably 100 nm to 400 nm, preferably 100 to 300 nm, preferably 100 nm to 200 nm, preferably 150 nm to 300 nm, or preferably 200 nm to 500 nm.

12. Optoelectronic component (100) according to any of the preceding claims, wherein the optoelectronic component (100) is a single-junction, tandem-, or multi-junction device, wherein preferably in the tandem- or multijunction device at least one further subcell (13) comprises an organic photoactive layer (10) having a small band-gap, wherein at least one donor and at least one acceptor absorber material are forming a donor/acceptor heterojunction.

13. A process for manufacturing an inorganic perovskite subcell (12) of an optoelectronic component (100), preferably a photovoltaic element, in particular according to any of claims 1 to 12, by vacuum deposition on a substrate (1), wherein the inorganic perovskite subcell (12) having a n-i-p cell architecture, the process comprising the following steps:
ii) applying an n-type layer b) (4) by evaporating a fullerene or a fullerene derivative as electron transport material (ETM);
iii) applying an intrinsic perovskite layer c) (5) comprising at least one inorganic perovskite as absorber material by co-evaporating of at least a first precursor and a second precursor, wherein the first precursor and the second precursor are each independently selected from the group consisting of CsCl, CsBr, CsI, PbCl₂, PbBr₂, and PbI₂;
iv) applying a doped p-type layer d) (7) by co-evaporating a hole transport material (HTM) and at least one p-dopant; and
v) obtaining the inorganic perovskite subcell (12) of the optoelectronic component (100).

14. The process according to claim 13, wherein the temperature of the substrate (1) is from 20°C to 120°C, preferably from 20°C to 80°C, preferably from 20°C to 60°C, or preferably from 20°C to 40°C.

15. The process according to claim 13 or 14, wherein at maximum a thermal annealing of the intrinsic perovskite layer c) (5) is carried out during or after step iii) at a temperature from 20°C to 120°C, preferably from 20°C to 80°C, preferably from 20°C to 60°C, preferably from 20°C to 50°C, preferably from 20°C to 40°C, or preferably from 20 to 30°C, or no thermal annealing of the intrinsic perovskite layer c) (5) is carried out during or after applying the intrinsic perovskite layer c) (5) in step iii).

16. The process according to any of claims 13 to 15, wherein after step iii) and before step iv) in an additional step iv1) an intrinsic p-type layer (6) is applied by vacuum deposition of a hole transport material (HTM).

17. The process according to any of claims 13 to 16, wherein the substrate (1) comprises a film, preferably the film is formed by a polymer layer, wherein preferably the substrate (1) is flexible.
